# EUROPEAN PATENT SPECIFICATION

(11) **EP 0 647 947 B1**
(45) Date of publication and mention of the grant of the patent: **06.08.2003**
(21) Application number: 94307419.5
(22) Date of filing: 10.10.1994
(51) Int. Cl.: G11C 16/04, H01L 27/115, G11C 16/06

(54) **Low voltage flash EEPROM X-cell using Fowler-Nordheim tunneling**
Niederspannungs-Flash-EEPROM-X-Zelle mit Fowler-Nordheim-Tunneling
Flash EEPROM cellule X à basse tension utilisant Fowler-Nordheim tunneling

(30) Priority: 12.10.1993 US 135813; 12.10.1993 US 135695
(43) Date of publication of application: 12.04.1995
(73) Proprietor: TEXAS INSTRUMENTS INCORPORATED, Dallas Texas 75265 (US)
(72) Inventor: D'Arrigo, Iano, F-06400 Cannes (FR); Smayling, Michael C., Missouri City, TX 77459 (US); Falessi, Georges, F-06610 LaGaude (FR); Marotta, Giulio G., I-02100 Rieti (IT); Santin, Giovanni, 02010 S. Rufina, Rieti (IT); Bhat, Mousumi, Austin, Texas 78705 (US)
(74) Representative: Nettleton, John Victor

(56) References cited:
- JP-A- 6 196 711
- US-A- 4 328 565
- US-A- 4 742 492
- US-A- 4 839 705
- US-A- 5 016 216
- US-A- 5 021 847

## Description

### TECHNICAL FIELD OF THE INVENTION

The present invention pertains in general to an erasable electrically programmable memory cell (EEPROM) and its related driving circuitry, and more particularly, to an EEPROM cell utilizing low voltage transistors.

### BACKGROUND OF THE INVENTION

Conventional EEPROMs typically employ three to four transistors, which include a tunnel diode device coupled to the floating gate of the sense transistor to charge the latter and a select or row transistor to activate the cell. The use of three or four transistors to realize a cell substantially limits the size reduction possible for EEPROM arrays. Furthermore, typical EEPROM cells require the application of voltages in excess of 15 volts. This therefore requires special processing to reduce leakage and a larger layout to avoid unwanted field transistor turn-on, i.e., the use of high voltage transistors typically have longer channel lengths, and therefore, significantly larger sizes. This is especially the case with respect to the row transistor, since high voltage is applied to the source during the ERASE mode. The peripheral driving circuitry also requires higher voltage transistors to handle these high voltage driving signals.

One technique for reducing the voltage is to utilize lower voltages during the programming and the ERASE modes with use of an asymmetric transistor. This is disclosed in U.S. Patent No. 4,939,558, issued July 30, 1990, which patent is incorporated herein by reference. U.S. Patent No. 4,939,558, discloses an asymmetric memory cell that utilizes FowlerNordheim tunneling techniques, whereby a reach-through region is provided on only one side of the floating gate, such that the tunneling of electrons takes place only on the reach-through side of the gate and, as such, creates an asymmetry in the transistor for the purposes of both programming and erasure.

US-A-5 021 847 (Eitan Boaz et al) 4 June 1991 discloses an EPROM array with plural rows of split gate transistors, where each transistor includes a floating gate and the floating gate has corner portions. A bit-line defining edge is formed on each floating gate between two of the corners. The bit-line defining edges of first and second floating gates respectively belonging to first and second rows are patterned so that these edges protrude into opposed side areas of a bit line implant window. In one example, the drain to source orientations of adjacent rows are opposed.

The present invention provides an electrically erasable, electrically programmable Read Only Memory as claimed in Claim 1.

In an example of the present invention, the transistors are arranged in an X-Cell configuration wherein the programming side of the transistors comprises the source with transistors from two adjacent modes having the sources thereof connected to the common Column Line and the other two transistors being from two rows with the drain thereof connected to the common Column Line.

In an example of the present invention, the flash Write circuitry is operable to connect a negative voltage to the control gates of all the transistors and a positive voltage to the sources and drains of all the transistors to selectively remove the negative charge from the floating gate of a select one of the transistors, a negative voltage is disposed on the row line associated with the select transistor and a positive voltage is disposed on the source of the select transistor, this associated with the programming side of the select transistor. The drain of the select transistor is connected to ground, as are the remaining row lines and the remaining Column Lines. The positive voltage is disposed at a medium voltage and the negative voltage is disposed at a negative medium voltage that is less than ground, such that the field across the gate/source is reduced. To utilize the negative medium voltage, the transistors are disposed in a high voltage tank.

### BRIEF DESCRIPTION OF THE DRAWINGS

For a more complete understanding of the present invention and the advantages thereof, reference is now made to the following description taken in conjunction with the accompanying Drawings in which:
FIGURE 1 illustrates a block diagram of the EEPROM;
FIGURE 2 illustrates a schematic diagram of the array;
FIGURE 3 illustrates a diagrammatic view of the cell layout for the array without the metal level;
FIGURE 4 illustrates a detail of one set of cells in the X-cell layout;
FIGURE 5 illustrates a cross-sectional view of one of the EEPROM memory cells;
FIGURE 6 illustrates an equivalent circuit for the transistor of FIGURE 5;
FIGURE 7 illustrates a cross-sectional view of a cell illustrating the high-voltage tank;
FIGURE 8 illustrates a schematic diagram of an H-cell layout utilizing the asymmetric cells of the present invention;
FIGURE 9 illustrates a top view of the layout of the H-cell configuration;
FIGURE 10 illustrates a block diagram of the electrical circuit for providing the various voltage levels required by each cell; and
FIGURE 11 illustrates a schematic diagram of a circuit for driving each Word Line of the array.

### DETAILED DESCRIPTION OF THE INVENTION

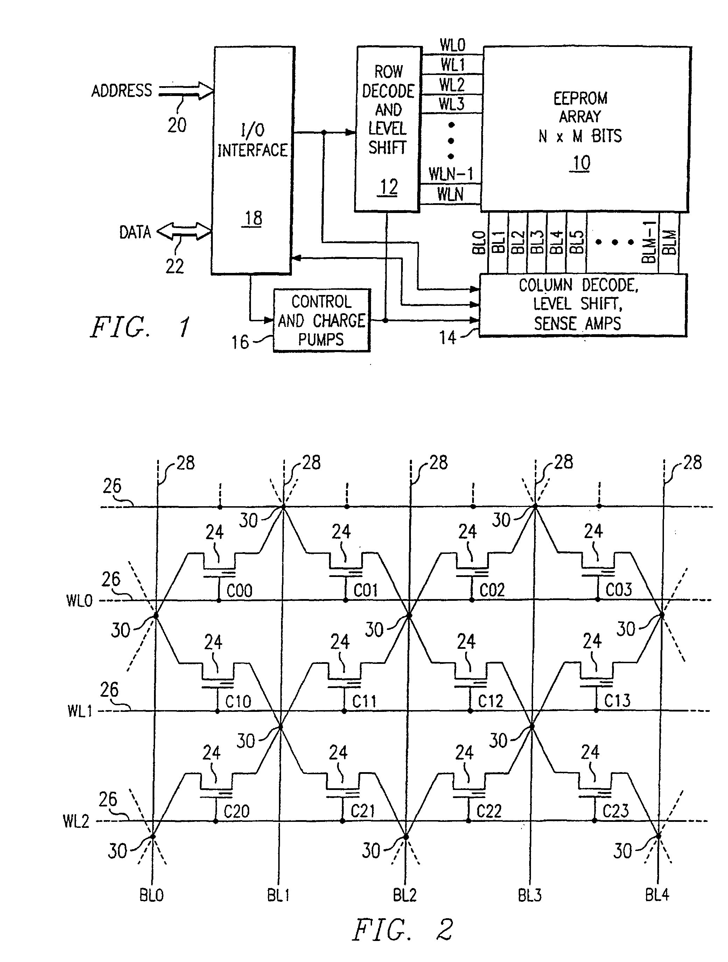

Referring now to FIGURE 1, there is illustrated a schematic block diagram of the architecture of an EEPROM memory which may stand alone as an independent integrated circuit, as well as being incorporated within a much higher level integrated circuit as a single module in that integrated circuit. The EEPROM memory includes an array 10 of memory cells which are arranged as N-rows and M-columns to provide an array of N x M bits. In a typical example, the array could be arranged to have 256 words with 8 bits per word, for a total of 2048 bits. These may be organized in an array of, for example, 32 rows by 64 columns, or 64 rows by 32 columns.

Each of the bits in the array 10 is associated with an EEPROM memory cell, as will be described hereinbelow. Each of the memory cells requires a dedicated Word Line and Bit Line with adjacent Word Lines and Bit Lines also utilized in the programming, as will also be described hereinbelow. A row decoder and level shifter 12 is provided for interfacing with the Word Lines to drive the Word Lines to the appropriate voltages. A column decoder, level shifter and sense amplifier section 14 is operable to drive the Bit Lines with the appropriate voltages and, during the Read operation, to attach the appropriate Bit Lines to sense amplifiers.

A block 16 includes circuitry for controlling the timing of the access to the EEPROM array 10 and charge pumps for providing control signals and appropriate voltages to the array 10, the row decode and level shift block 12 and the column decode, level shift and sense amplifier section 14. The control and charge pump block 16 is connected to an input/output (I/O) interface 18, which provides an interface with either the rest of the chip or with an external chip or device to receive address signals therefrom and also input and output data. The I/O interface 18 uses addresses from an address bus 20 and receives data from and transfers data to a data bus 22.

Referring now to FIGURE 2, there is illustrated a detailed diagram of the array. A plurality of asymmetric EEPROM transistor cells are provided which are asymmetric floating gate cells, as will be described in more detail hereinbelow. The symbol for the memory cells 24 illustrates a floating gate disposed between a control gate and a channel region which is asymmetric in nature, such that the floating gate is disposed on one side only, this being the "programming" side. A plurality of Word Lines 26 are provided, one for each row of memory cells 24, the Word Lines 26 connected to the control gates of respective memory cells 24. A plurality of Column Lines 28 are provided, each connected to a plurality of X-Cell nodes 30 and each designated as a Bit Line. As described above, the column decode, level shift and sense amplifier section 14 is operable to control the connection to each of the Column Lines 28. The architecture of the array of FIGURE 2 is a conventional X-Cell, as will be described hereinbelow.

In the example of FIGURE 2, three Word Lines 26 are labelled WL0, WL1 and WL2, and five of the Column Lines 28 are labelled BL0, BL1, BL2, BL3 and BL4. The memory cells 24 associated with Word Line WL0 and the Column Lines labelled BL0-BL4 are each labelled C00, C01, C02 and C03. Similarly, the memory cells 24 associated with Word Line WL1 and the Bit Lines BL0-BL4 are labelled C10, C11, C12 and C13. The memory cells 24 associated with the Word Line 26 labelled WL2 and the Column Lines 28 labelled BL0-BL4 are labelled C20, C21, C22 and C23.

Each of the memory cells 24 has the drain thereof connected to one of the X-Cell nodes 30 in one Column Line 28 and the source thereof connected to one of the X-Cell nodes 30 on an adjacent Column Line 28. The source of each of the memory cells 24, as will be described hereinbelow, has the asymmetric reach-through region or "programming" side associated therewith, such that tunneling of electrons occurs only on the source side, and thus can only be programmed from that side. For example, the memory cell 24, labelled C00, has the drain thereof connected to the X-Cell node 30 on Column Line 28 labelled BL0 and the source thereof connected to the X-Cell node 30 on the Column Line 28, labelled BL1.

In order to write to the cells, i.e., to negatively charge the floating gates, it is necessary to dispose the Word Lines 26 at a positive voltage, and the sources and drains thereof at a negative voltage such that a field is impressed across the gate, to allow electrons to tunnel from the source side of each of the memory cells 24 to the floating gates thereof. This can be achieved in two ways. In one method, a high voltage level of approximately 18 volts can be disposed on all of the Word Lines 26 with the Column Lines 28 disposed at ground or zero volts. Alternately, and in the preferred embodiment, the Word Lines 26 are disposed at a medium voltage of approximately 9 volts and the Column Lines 28 are disposed at a negative medium voltage of -9 volts. In order to FLASH ERASE the cells, it is only necessary to then dispose the Word Lines at the negative medium voltage and the Column Lines at the positive medium voltage.

In order to selectively ERASE one of the cells such that individual bit programming can be provided, it is necessary to dispose a positive voltage on the source of a select transistor relative to the control gate thereof. However, it is also important that the remaining voltages of adjacent cells and other cells in the array be disposed such that the charge on the control gate is not disturbed. By way of example, consider the memory cell 24 labelled C11.

The following Table 1 illustrates the voltages necessary for both the FLASH WRITE, the ERASE, the READ and FLASH ERASE operation.

**TABLE 1**

| MODE | WL0 | WL1 | WL2 | BL0 | BL1 | BL2 | BL3 | BL4 |
|---|---|---|---|---|---|---|---|---|
| Flash Write | +MV | +MV | +MV | -MV | -MV | -MV | -MV | -MV |
| | +HV | +HV | +HV | 0V | 0V | 0V | 0V | 0V |
| Erase C11 | 0V | -MV | 0V | 0V | 0V | +MV | 0V | 0V |
| Read C11 | -Vr | +Vr | -Vr | Float | 0v | Vs | Float | Float |
| Flash Erase | -MV | -MV | -MV | +MV | +MV | +MV | +MV | +MV |

where:
- HV: = High Voltage (18V)
- MV: = Medium Voltage (9V)
- Vr: = Word Line Read Voltage (3V)
- Vs: = Bit Line Sense Voltage (1.2V)

To erase cell C11, all the Word Lines 26 are disposed at a zero voltage with the exception of WL1, which is disposed at a negative medium voltage. The Column Lines 28 are all disposed at a value of zero volts, with the exception of the BL2 Column Line, this being disposed at a positive medium voltage. Therefore, the programming side of the cell 24 will have a voltage of 18 volts disposed across the associated tunnel diode for the purpose of depleting charge from the floating gate without requiring the high node potentials necessary for a normal EEPROM cell. However, with an X-Cell arrangement, it is important to ensure that all of the memory cells 24 in the row associated with the Word Line 26 labelled WL1 not have the charge therein disturbed and that the memory cells 24 having the sources thereof connected to the Bit Line BL2 not have the charge on the control gates thereof disturbed. Since a positive medium voltage is disposed on all of the sources of the memory cells 24 associated with the Bit Line BL2, each of the memory cells 24 will have at least the medium voltage disposed between the control gate and source thereof. Further, each of the memory cells 24 associated with the Word Line WL1 will also have at least a medium voltage disposed between a control gate and source thereof. For the most part, all of these memory cells 24, with the exception of the memory cell C11 and the memory cell C12, have only the medium voltage disposed between the source and gate thereof. This is an insufficient level to affect the programming operation and perform an erase. However, the memory cell 24 labelled C12 has a negative medium voltage disposed on the control gate thereof and a positive medium voltage disposed on the drain thereof. Since the memory cell 24 is "asymmetric", the tunneling occurs only on the source side, and therefore, the memory cell C12 does not have the charge on the floating gate thereof disturbed. This will be described in more detail hereinbelow.

In order to read the memory cell C11, the Word Line WL1 has a positive read voltage of approximately 3 volts disposed thereon such that the control gate of the memory cell C11 is disposed at 3 volts. All of the Column Lines 28 are allowed to float with the exception of the two Column Lines 28 connected to the source and drain of the memory cell C11. The Column Line 28 associated with the source of the memory cell C11 is connected to the Bit Line sense voltage, which is approximately 1.2 volts and the Column Line 28 associated with the drain of the memory cell C11 is connected to zero volts. Therefore, if a memory cell has been erased it will conduct and, if it has not been erased, it will not conduct. It can also be seen that the Column Lines 28 perform both a virtual ground operation and a sense operation. It will therefore be required for each memory cell to have associated therewith two Column Lines, such that the memory cells at the initial position will have an extra Column Line associated therewith.

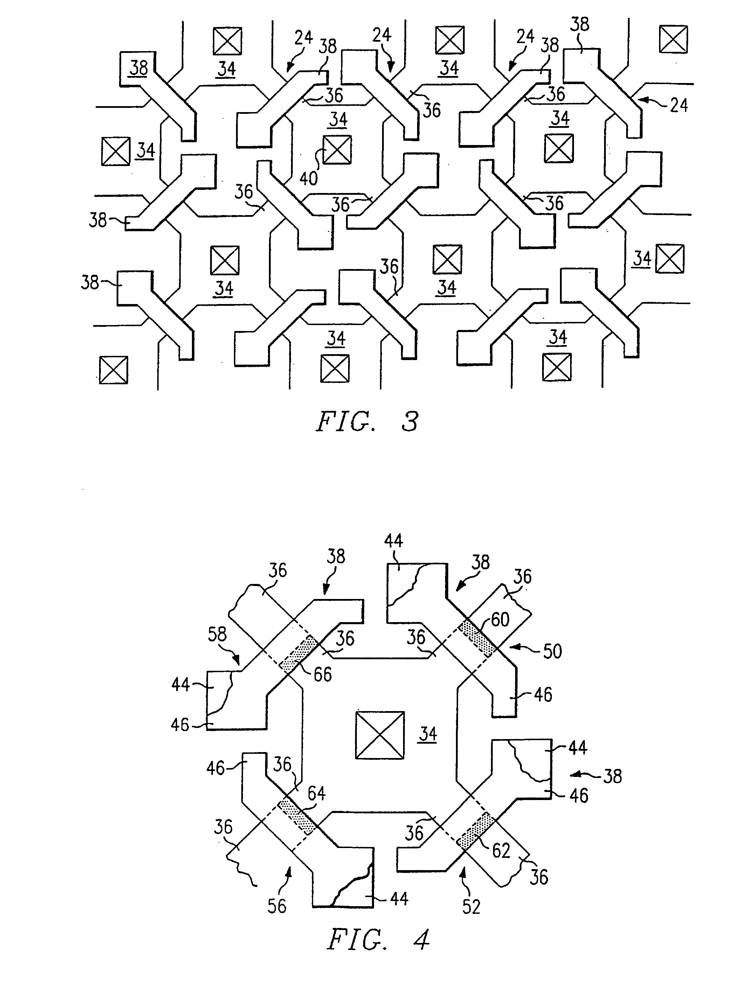

Referring now to FIGURE 3, there is illustrated a layout for the array of FIGURE 2. A plurality of centralized N+ diffusion regions are provided that are arranged in rows and columns and have associated therewith source/drain regions 36 extending from the corners thereof, each of the diffusion regions 34 being substantially rectangular in configuration with the source/drain regions 36 extending from the corners thereof. The diffusion regions 34 are arranged such that they are staggered and the corners of the regions 34 in adjacent rows are aligned to form an X-Cell configuration. A floating gate structure 38 is disposed between the source/drain regions 36 of adjacent diffusion regions 34 to form a channel therebetween. This therefore defines a transistor. The X-Cell configuration is well known and provides a very compact layout structure. However, the present embodiment does not utilize control transistors for bit programming; rather, the asymmetric nature of the transistors and the lower positive voltages provide for smaller low voltage transistors and bit-wide programming without the need for an additional control transistor. The Column Lines 28 are not illustrated, but they are fabricated from upper level metal layers, with a contact 40 disposed in the middle of each of the diffusion regions 34 for contact with the Column Lines 28. The row lines 26 are not illustrated but they are directly over the floating gate structures 38 and are associated with each row of the transistors 24.

During fabrication, the first Poly layer is formed and then the "ends" of the floating gates defined. A layer of interlevel oxide (ILO) is then deposited followed by a second layer of Poly. The second layer of Poly is patterned to define the row lines and the remainder of the floating gate structure 38. This is a self aligned structure to allow for alignment of the source and drain junctions with the edge of the floating gate structure 38, this being a conventional process.

Referring now to FIGURE 4, there is illustrated a detailed layout of one of the diffusion regions 34 and four of the transistors associated therewith. Each of the floating gate structures 38 are comprised of a floating gate 44 disposed over the channel region between the source/drain regions 36 and separated therefrom by an insulating oxide layer of approximately 100 Å. The floating gate 44 is formed from a layer of doped poly. Thereafter, an interlevel oxide (ILO) layer of an oxide/nitride sandwich material is disposed over the control gate 44 to a thickness of approximately 300 Å. A control gate is then disposed over the floating gate 44 s the row line (not shown). Typically, as will be described hereinbelow, this is a self-aligned process, wherein a first layer of polysilicon is disposed over the substrate followed by formation of the ILO on the upper surface thereof. The second polysilicon layer is then disposed over the ILO and then patterned and etched to form the overall row line/control gate/floating gate structure. It is noted that the row line/control gate/floating gate structure extends over the field oxide layer to provide a higher degree of coupling between the floating gate 44 and the control gate.

The transistors associated with the region 34, although formed such that the source/drain regions associated with the diffusion region 34 share a common conductive area, are "asymmetric". This asymmetry results in a reach-through region being formed on only one side of the channel. There are illustrated four transistors, transistor 50, transistor 52, transistor 56 and transistor 58 formed about the common diffusion region 34. However, transistor 50 has a reach-through region 60 formed on the opposite side of the channel from the diffusion region 34 and the transistor 52 also has a reach-through region 62 formed on the opposite side of the channel region from the diffusion region 34. Therefore, the transistors 50 and 52 have the drains thereof connected to the diffusion region 34. Conversely, transistor 56 has a reach-through region 64 disposed on the same side of the channel region thereof as the common diffusion region 34, and transistor 52 has a reach-through region 66 disposed on the same side of the channel region of transistor 58 as the diffusion region 34. Therefore. The diffusion region 34 constitutes the sources of the transistors 56 and 58. As such, in order to erase the transistors 58 and 56, it is necessary to dispose the negative medium voltage on the control gates of transistors 56 and 58 and dispose a positive medium voltage on the region 34. However, if a negative medium voltage is disposed on the control gates of either the transistors 50 or 52, they will not have the charge on the floating gate 44 disturbed, due to the asymmetric construction.

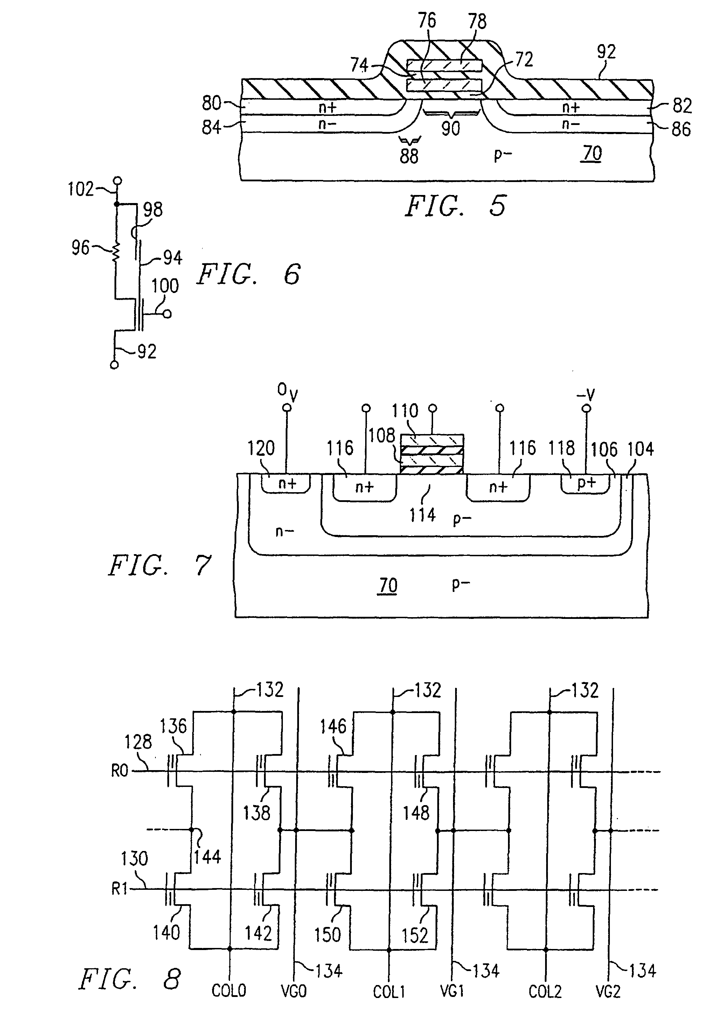

Referring now to FIGURE 5, there is illustrated a cross-sectional diagram of each of the transistors 50, 52, 56 and 58 taken through the channel region. This transistor is an N-channel transistor which is formed on a P-type substrate 70. The active region is formed in a conventional manner and, thereafter, a layer of thin oxide grown by thermal oxidation to a thickness of approximately 100 Å to form a gate oxide layer 72. A layer of polycrystalline silicon (Poly) is disposed over the entire surface using standard techniques to a thickness of about 2000 Å. It is then patterned to define the various floating gates and the separation therebetween. This is followed by the formation of the layer of gate oxide to a thickness of approximately 300 Å, which will form the gate oxide layer 74 between the floating gate and the control gate. This is followed by deposition of a second level Poly layer over the entire surface and then patterning and etching of both the first Poly layer and the second Poly layer to form a floating gate 76 and a control gate 78, this being a self-aligned process. As such, the floating gate 76 will be separated from the substrate 70 by the thin gate oxide layer 72 and the control gate 78 will be separated from the floating gate 76 by the thicker gate oxide layer 74.

Following the formation of the floating gate 76 and control gate 78, a layer of oxide is formed over the entire surface to provide a conformal layer of oxide. This layer is then subjected to a directional or anisotropic etch using a plasma etch, as disclosed in U.S. Patent No. 4,297,162, for example, to remove the oxide on all horizontal surfaces and leave sidewall oxide layers on the sidewalls of the floating gate 76 and gate electrode 78. This is a conventional technique. Thereafter, a resist layer is applied and patterned such that only one of the sidewall oxide layers will remain. This will remove the sidewall oxide layer from the source side of the transistor.

The photoresist layer is removed and then an arsenic implant is performed to create heavily doped source/drain regions 80 and 82. This is followed by a phosphorous implant to a dosage of about 8 x 10¹⁴ to 2 x 10¹⁴ ions per cm³. The substrate is then annealed at a temperature of approximately 950 ºC to 1000 ºC to cause lateral diffusion of the phosphorous implant, resulting in lightly doped regions 84 and 86, region 84 underlying region 80 and region 86 underlying region 82. It is noted that region 84 underlies a portion of the floating gate 76. This is referred to as a reach-through region 88, it being noted that, due to the way the sidewall oxides were formed, that the region 86 does not undercut the floating gate 76. As such, whenever a high voltage is disposed on the control gate 78 and a low voltage disposed on the source/drain implant 80, comprising the source of the transistor in this example, Fowler-Nordheim tunneling will occur at the reach-through region 80 and electrons will flow therethrough to the floating gate 76 to negatively charge the floating gate 76, thereby raising the threshold of the transistor. The channel region of the transistor comprises an area 90 disposed between the regions 84 and 86.

After formation of the source/drain regions 82 and the reach-through region 88, a layer of oxide 92 is disposed over the substrate, followed by formation of source/drain contacts (not shown) and the formation of metal layers (not shown) to contact the various regions. The structure of the transistor of FIGURE 5 is disclosed in U.S. Patent No. 4,742,492, issued May 3, 1988, which is incorporated herein by reference.

Referring now to FIGURE 6, there is illustrated an equivalent circuit for the transistor of FIGURE 5. The transistor consists of a drain 92, a floating gate 94, a body resistance corresponding to the reach-through region 88 and a tunnel diode 98. The tunnel diode 98 constitutes the reach-through path of the reach-through region 88 overlapped by the floating gate 94. A control gate 100 is disposed over the floating gate and a source 102 is connected to the other side of the body resistance 96. With the drain 92 floating, the source 102 disposed at ground potential and a high voltage applied to a control gate 100, tunneling of electrons will occur across the oxide layer 72 in the reach-through region 88. This will charge the floating gate negatively. This corresponds to a WRITE operation. In an ERASE mode, the drain 92 will again float, the source 18 will be disposed at a positive voltage, in the preferred embodiment the medium voltage, and a negative medium voltage will be applied to the control gate 100. This will cause electrons to tunnel from the floating gate 94 to the reach-through region 88 and charge the floating gate 94 positively.

In the READ mode, the source 102 is disposed at a precharged voltage and then a voltage of 3.0 volts is disposed on the control gate 100, which is connected to the row line of the array when the transistor is selected. If it is not selected, a voltage of -3.0 volts is disposed on the control gate of the transistor. With a negatively charged floating gate 94, no current will flow through the channel and the pre-charge voltage will therefore remain constant. However, if the floating gate 94 has been positively charged, then current will flow from the source 102 to the drain 92 and the precharged voltage will fall. This is then sensed by the sense amplifier. However, an alternate method can be utilized, wherein the Bit Line is precharged and the source of the transistor disposed at ground and the sense amplifier then sensing the precharged voltage to determine if the transistor is conductive

Referring now to FIGURE 7, there is illustrated a more detailed diagram of how the transistor is protected from unwanted parasitic transistors. In this technique, the substrate 70 has an N- well 104 formed therein by implanting a low dosage of N-type impurities into the substrate 70. This is followed by the formation of a P- region 106 within the N- region 104. The regions are driven into the substrate 70 by an annealing process such that the region 104 is driven deeper than the region 106 and, therefore, the N- region 104 surrounds the P-region 106. Thereafter, a transistor is formed with a stacked gate comprised of a floating gate 108 and control gate 110 formed over a channel region 114. Thereafter, N+ source/drain regions 116 are formed on either side of the channel region 114 in accordance with the techniques described above with respect to FIGURE 5. A P+ contact region 118 is formed in the P- region 106 and an N+ contact region 120 is formed in the N- region 104. The N+ region 120 is disposed at a ground reference voltage and the P- region 106 is disposed at a negative voltage relative to the N- region 104. As such, the PN junction between regions 104 and 106 will be reverse biased and, therefore, the current will not flow. Therefore, whenever the source of the transistor at one of the source/drain regions 116 is disposed at a negative voltage relative to the P- substrate 70, conduction will not occur across the PN junction. This constitutes a high voltage tank structure, which is described in U.S. Patent No. 5,157,281, issued October 20, 1992, which is incorporated herein by reference.

Referring now to FIGURE 8, there is illustrated an array utilizing an H-cell configuration and the asymmetric transistors of the present invention. The array is illustrated with two row lines 128, labelled R0, and 130, labelled R1. A plurality of Column Lines 132 are illustrated labelled COL0, COL1 and COL2. A plurality of virtual ground lines 134 are illustrated labelled VG0, VG1 and VG2.

Each of the Column Lines 132 has four memory cells associated therewith. Column Line COL0 has memory cells 136, 138, 140 and 142 associated therewith, each comprising an asymmetric transistor, as described above with reference to FIGURE 2. Each of the transistors 136-142 has the other side of the source/drain paths thereof connected to a node 144, with the other side of the source/drain paths of transistors 138 and 142 connected together and to the VG0 line 134. The Column Line COL1 has four memory cells 146, 148, 150 and 152 associated therewith. However, the transistors 146-152 are configured such that the side of the source/drain path of each of the transistors opposite to the programming side thereof is connected to the Column Line COL1. The programming sides of the transistors 146 and 150 are connected to the virtual ground lines VG0 and the programming side of the transistors 148 and 152 are connected to the virtual ground line VG1.

In order to FLASH WRITE all of the memory cells, it is necessary to apply a positive medium voltage to all the row lines and then apply a negative medium voltage to all of the column or virtual ground lines. This will thereby negatively charge the floating gates. In order to selectively ERASE one of the cells, it is necessary to dispose the associated row line at a negative medium voltage, and dispose the one of the associated virtual ground lines or Column Lines connected to the programming side of the transistors at a positive medium voltage with the remaining virtual ground lines and Column Lines remaining at a zero voltage. For example, if memory cell 146 were to be erased, it would be necessary to dispose the row line 128 at a negative voltage and the programming side of the transistor 146 connected to the VG0 line at a positive voltage. The row line 130 connected to the control gate of transistor 150 would be disposed at a zero voltage such that only the medium voltage is disposed across the gate and source thereof, and not the full programming voltage. Therefore, the charge on the floating gate of transistor 150 would not be disturbed. Further, the two transistors 138 and 142, having the "drains" thereof connected to the VG0 line, would not have the charge on the floating gates thereof disturbed, since the programming side of the transistors is not connected to the VG0 line. It is noted that when either the transistors 138 or 142 are erased, it is necessary to dispose the Column Line COL0 at the positive medium voltage with the selected gate of the erased one of the transistors connected to a negative medium voltage. During a Read operation, the row associated with the selected transistors is connected to +3 volts, the associated virtual ground line connected to a precharged voltage and the associated Column Line connected to the sense amp. For example, if transistor 146 were to be READ, the row line 121 would be connected to a positive three volts, the row line 130 connected to a negative three volts, the VG0 line connected to a precharged voltage and the Column Line COL1 connected to a sense amp. This would effectively turn off transistor 150 such that the sense amp would only sense conduction or no conduction through the transistor 146. Alternately, the virtual ground line could be connected to ground and the Column Line precharged. The sense amp would then sense whether the selected cell discharged the Column Line to determine if it was conductive.

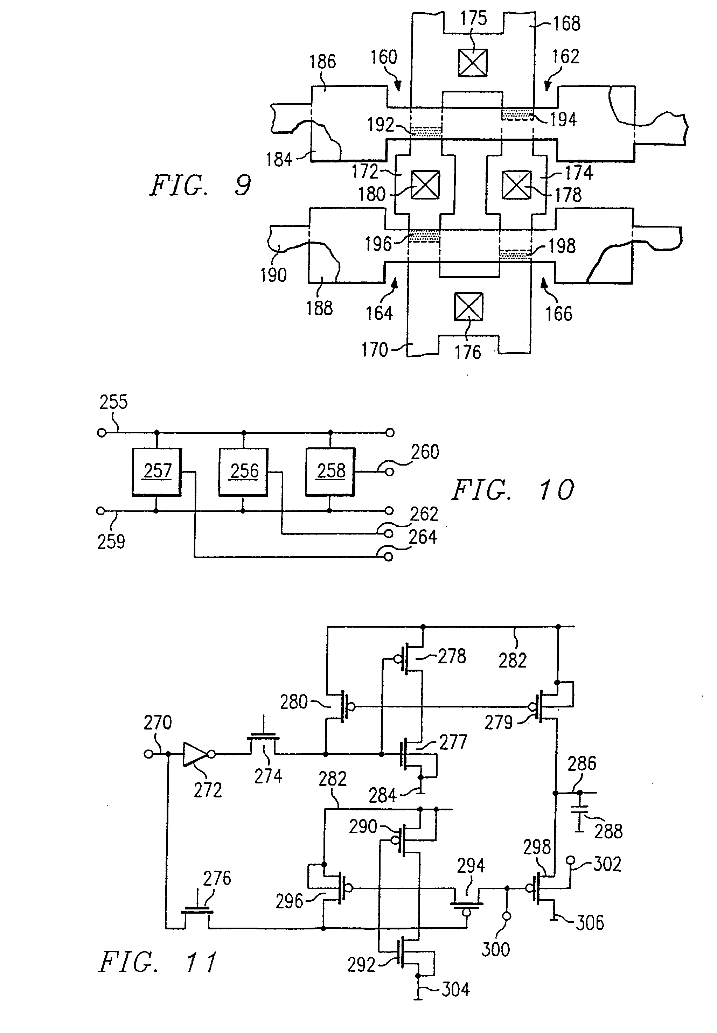

Referring now to FIGURE 9, there is illustrated a layout for the array of FIGURE 8, illustrating transistors 160, 162, 164 and 166. A common diffusion region 168 is provided which constitutes the programming side of transistor 162 and the non-programming side of transistor 160. A common diffusion region 160 is provided which constitutes the programming side of transistor 166 and the non-programming side of transistor 164. The other source/drain diffusion of transistors 160 and 164 is a common diffusion region 172. Similarly, a common diffusion region 174 is provided which constitutes the other source/drain regions of transistors 166 and 168. A contact 175 is provided to the diffusion region 168 and a contact 176 is provided to the diffusion region 170. A contact 178 is provided to the source/drain region 174 and a contact 180 is provided to the source/drain region 172.

A control gate/floating gate structure is provided over each of the channel regions of the transistors 160-166. The control gate/floating gate structure of transistors 160 and 162 is comprised of a floating gate 184 that underlies a control gate 186. The control gate 186 constitutes the row line of the transistors 160 and 162. Similarly, a floating gate 188 underlies a control gate 190, which constitutes a control gate/floating gate structure for transistors 164 and 166.

Transistor 160 has a reach-through region 192 associated therewith on the source/drain region 172 side. The transistor 162 has a reach-through region 194 on the diffusion region 168 side thereof. The transistor 164 has a reach-through region 196 on the source/drain region 172 side thereof. The transistor 166 has a reach-through region 198 on the diffusion region 170 side thereof.

The circuitry required to drive the cells 24 illustrated in FIGURE 2 is indicated by FIGURES 10 and 11. FIGURE 10 shows a block diagram form the circuit required to produce the bipolar voltage levels required while FIGURE 11 shows a switching circuit required to drive each line with a voltage required for a particular mode of operation.

In FIGURE 10, a single voltage source of, for example, 5 volts is used as an input along line a 255 with a line 259 being ground or substrate voltage. Three charge pumps 257, 256 and 258 the design of which are well known in the art are coupled in parallel across lines 258 and 259. Each charge pump 257, 256 and 258 produces output voltages -V_{gg}, -Vₚₚ and +Vₚₚ on associated output lines 264, 262 and 260, respectively.

The circuit of FIGURE 11 functions in response to input control signals received on input line 270 which are fed in parallel to an inverter 272 and through the source-to-drain of a field effect transistor 276 whose gate is at V_{dd} or +5 volts. The inverter 272 output also passes through a field effect transistor 274 whose gate is at V_{dd} or +5V. The output from transistor 274 couples in parallel to the gates of an N-channel transistor 277 and a P-channel transistor 278 and to the drain of a P-channel transistor 280 to which the source of transistor 280 connects to the Vₚₚ line 282 and its gate connects to the drain of transistor 277. The source of transistor 277 is connected to ground at a Vₛₛ line 284 while the source of transistor 278 is connected to the Vₚₚ line 282.

The output from transistor 276 couples to the gates of transistors 290, 292 and 294, with transistors 290 and 294 being P-channel transistors. The drains of transistors 290 and 292 couple to the gate of transistor 296 and to the source of transistor 294. The drain of transistor 294 couples both to a V_{gg} line 300 and to the gate of a P-channel transistor 298. Transistor 296 has the source thereof connected to the Vₚₚ line 282 and the drain thereof connected an output of transistor 276. The source of transistor 290 connects to the Vₚₚ line 282 while the source of transistor 292 is connected to the Vₛₛ line 104.

Output transistor 279 has the source thereof connected to the Vₚₚ line 282 and the drain thereof connected to the output line 286 while its complementary driver transistor 298 has the drain thereof connected to the-Vₚₚ line 306 and the source thereof connected to the line 286. Line 286 is charged and discharged by output capacitor 288 connected to Vₛₛ.

In operation, a zero voltage input on input line 270 results in a positive signal at the output of inverter 272 which is applied to the gates of transistors 277 and 278. In response, transistor 277 turns on grounding the gates of transistors 279 and 280 and turning on both of the latter. Thus, transistor 279 in turning on connects the Vₚₚ line 282 to the output line 286. The charge pump 258 is operative to charge capacitor 288 to +Vₚₚ. Simultaneously, transistor 280 couples Vₚₚ line 282 to the gates of transistors 277 and 278 thereby maintaining transistor 277 in an ON state and ensuring that there is no net voltage across the source-gate of transistor 278 so that the latter is cut off. Transistor 274 blocks the transmission of Vₚₚ to the output of inverter 272. Thus, capacitor 288 is charged through the channel resistance of transistor 279 to Vₚₚ.

A zero output applied through transistor 276 turns on transistors 290 and 294 coupling +Vₚₚ on line 282 to the gate of transistor 298 and maintaining the latter OFF.

With an input signal at a logic "1", inverter 272 applies a logic "0" signal to the gates of transistors 277 and 278 turning on transistor 278 and applying Vₚₚ on line 282 to the gate of transistor 279. Transistor 279 is thus turned and/or maintained OFF.

An input signal at the logic "1" state turns on transistor 92 which applies zero volts to the source of transistor 292 and maintains the latter off. The -V_{gg} and -Vₚₚ charge pumps 257 and 256 are then activated and transistor 298 turns on charging line 286 towards -Vₚₚ. At the same time the Vₚₚ line 282 is tied to V_{dd} lines 255.

Clearly, a variety of different voltages could be produced by the circuit of FIGURE 10 depending upon the requirements. For the cells of FIGURE 1, the combination +18v, -9v and 3.0v, 0v and -3v would be appropriate for the row line, and +9v and 0v for the bit or read line.

In summary, there has been provided a Flash EEPROM memory array that utilizes an X-Cell layout. Each of the cells in the X-Cell layout is comprised of a floating gate EEPROM memory cell which is asymmetric in that it can only be programmed from one side thereof. Each of the Column Lines has common diffusion nodes which are connected to the sources of two transistors in separate rows and to the drains of two transistors in two separate rows. The programming side of the transistors is such that, in a given row, only one of the transistors has the programming side thereof connected to the common diffusion region. The entire array is subjected to a FLASH WRITE operation by disposing the row lines at a positive medium voltage and the Column Lines at a negative medium voltage to negatively charge the floating gates via a Fowler-Nordheim tunneling diode on the programming side of the transistors. Each of the cells can be selectively erased for the purposes of programming thereof by disposing all the Column Lines at a zero voltage with the exception of the Column Line associated with the select transistor, this being disposed at a positive medium voltage. The Word Line for the select transistor is disposed at a negative medium voltage. With respect to the two transistors associated with the same Column Line and same row line, only the one having the programming side connected to the Column Line will be erased. Each of the transistors in each of the memory cells is disposed in a high voltage tank that is of opposite conductivity type to that surrounding the channel region. The voltage of this high voltage tank is at a voltage less than the substrate such that a reverse biased PN junction is formed, thus allowing negative voltages to be placed on the source/drain of the memory cell transistors.

Although the preferred embodiment has been described in detail, it should be understood that various changes, substitutions and alterations can be made therein without departing from the scope of the invention as defined by the appended claims.

## Claims

1. An electrically erasable, electrically programmable Read Only Memory having a memory array (10), the memory array comprising:
a plurality of asymmetric storage transistors (50,52,56,58) arranged in rows and columns, said asymmetric transistors having a control gate (78), a source (102) and a drain (92) separated by a channel, and a floating gate (38), said asymmetric transistors operable to be programmed by Fowler-Nordheim tunneling from only one side of said channel, which comprises a programming side of said channel;
a plurality of row lines (26), each associated with one of said rows of said asymmetric transistors and connected to the control gates of the associated asymmetric transistors;
a plurality of column lines (28), each associated with one of the columns of said asymmetric transistors;
each of said asymmetric transistors (50,52,56,58) having the source (102) thereof connected to one of said column lines (28) and the drain (92) thereof connected to another of said column lines, at least two of said asymmetric transistors in the same row having one of the source or drains thereof connected to a common one of said column lines, such that the programming side of only one of said at least two asymmetric transistors is connected to said common column line;
flash Write circuitry for negatively charging the floating gates of substantially all of said asymmetric transistors;
selective erase circuitry for selectively removing charge from a selective one of said at least two asymmetric transistors; and
read circuitry for selectively determining if said floating gate for a selected one of said at least two asymmetric transistors is negatively charged, wherein said array comprises:
a semiconductor substrate having a plurality of substantially rectangular diffusion regions (34) arranged in rows and columns, and wherein:
respective first, second, third and fourth source/drain regions (36) for said asymmetric transistors extend from the corners of each diffusion region (34), in each diffusion region there being a respective source/drain doped region (80, 82) for each of said source/drain regions (36),
a respective floating gate structure (38, 76) for each asymmetric transistor is disposed between the source/drain regions (36) of adjacent diffusion regions (34) to form a channel therebetween,
a respective control gate structure (78) for each asymmetric transistor is disposed over each floating gate structure (76),
a respective Fowler-Nordheim tunneling reach-through region for each transistor is defined by a doped region (84) underlying an associated one of the source/drain doped regions (80) and underlying a portion of the associated floating gate (76), and
a respective further doped region (86) for each transistor underlies another associated one of the source/drain doped regions (82) but does not undercut the associated floating gate (76), each column line (28) is connected to respective ones of said diffusion regions (34).

2. The memory of Claim 1, wherein the programming side of each of said asymmetric transistors (50,52,56,58) is the source (102) thereof.

3. The memory of Claim 1, wherein each of said asymmetric transistors (50,52,56,58) has the source (102) thereof connected to one of said column lines (28) and the drain (92) thereof connected to an adjacent one of said column lines.

4. The memory of Claim 1, wherein at least four of said asymmetric transistors (50,52,56,58) have the source or drain thereof connected to a common one of said column lines, said four transistors comprising two of said asymmetric transistors from one of said rows and two of said asymmetric transistors from another of said rows and wherein the ones of said four transistors in a common row are oriented such that the programming side of only one of said asymmetric transistors in a common row is connected to said common column line.

5. The memory of Claim 4, wherein said four transistors (50,52,56,58) are arranged in an X-Cell configuration.

6. The memory of Claim 5, wherein each of said asymmetric transistors (50,52,56,58) is contained within a high voltage tank, said high voltage tank being of the same conductivity type of the source and drain of each of said asymmetric transistors and connected to a voltage less than the semiconductor material surrounding the source and drain of said associated asymmetric transistor such that a reverse biased PN junction is formed.

7. The memory of Claim 1, wherein said selective erase circuitry comprises:
a positive voltage;
a negative voltage; and
circuitry for connecting said negative voltage to the one of said column lines associated with the programming side of the select one of said two asymmetric transistors and said positive voltage to said row line associated with the select one of said two transistors.

8. The memory of Claim 7, wherein said negative voltage is less than a ground voltage and said positive voltage is greater than said ground voltage.

9. The memory of Claim 7, wherein the absolute value of said negative voltage is substantially equal to said positive voltage.

10. The memory of Claim 9, wherein each of said asymmetric transistors (50,52,56,58) is contained within a high voltage tank, said high voltage tank being of the same conductivity type of the source and drain of each of said asymmetric transistors and connected to a voltage less than the semiconductor material surrounding the source and drain of said associated asymmetric transistor such that a reverse biased PN junction is formed.

11. The memory of Claim 1, wherein said flash Write circuitry comprises:
a positive voltage;
a negative voltage; and
circuitry for connecting said negative voltage to all of said column lines and said positive voltage to all of said row lines.

12. The memory of Claim 7, wherein said negative voltage is less than a ground voltage and said positive voltage is greater than said ground voltage.

13. The memory of Claim 7, wherein the absolute value of said negative voltage is substantially equal to said positive voltage.

14. The memory of Claim 1, wherein said Read circuitry comprises:
a positive Read voltage;
a negative Read voltage;
circuitry for connecting said positive Read voltage to the one of said row lines (26) associated with a select one of said asymmetric transistors and said negative voltage to the remaining ones of said row lines (26); and
a sensing circuit for disposing a voltage across the channel of the source (102) and drain (92) of said asymmetric transistor to determine if it conducts.

15. The memory of Claim 14, wherein each of said asymmetric transistors (50,52,56,58) is contained within a high voltage tank, said high voltage tank being of the same conductivity type of the source and drain of each of said asymmetric transistors and connected to a voltage less than the semiconductor material surrounding the source (102) and drain (92) of said associated asymmetric transistor such that a reverse biased PN junction is formed.

16. The memory of Claim 14, wherein said negative Read voltage is ground.

17. The memory of Claim 14, wherein said negative Read voltage is a voltage less than a ground voltage and said positive Read voltage is greater than said ground voltage.

## Patentansprüche

1. Elektrisch löschbarer, elektrisch programmierbarer ROM-Speicher, der eine Speichermehrfachanordnung (10) aufweist, wobei die Speichermehrfachanordnung folgendes umfaßt:
mehrere asymmetrische Speichertransistoren (50, 52, 56, 58), die in Reihen und Spalten angeordnet sind, wobei die asymmetrischen Transistoren ein Steuergate (78), eine Source (102) und einen Drain (92), die durch einen Kanal getrennt sind, und ein Floating-Gate (38) aufweisen, wobei die asymmetrischen Transistoren so betreibbar sind, daß sie durch Fowler-Nordheim-Tunneln nur von einer Seite des Kanals, die eine Programmierseite des Kanals umfaßt, programmiert werden können;
mehrere Reihenleitungen (26), die jeweils einer Reihe der asymmetrischen Transistoren zugeordnet sind und die mit den Steuergates der zugeordneten asymmetrischen Transistoren verbunden sind;
mehrere Spaltenleitungen (28), die jeweils einer Spalte der asymmetrischen Transistoren zugeordnet sind;
jeder der asymmetrischen Transistoren (50, 52, 56, 58) eine Verbindung seiner Source (102) mit einer der Spaltenleitungen (28) und seines Drains (92) mit einer anderen der Spaltenleitungen aufweist, wobei wenigstens zwei der asymmetrischen Transistoren in der gleichen Reihe eine Verbindung ihrer Source-Anschlüsse oder Drain-Anschlüsse mit einer der Spaltenleitungen aufweisen, die sie gemeinsam haben, so daß die Programmierseite von nur einem der wenigstens zwei asymmetrischen Transistoren mit der gemeinsamen Spaltenleitung verbunden ist;
einen Flash-Schreib-Schaltkreis zum negativen Aufladen der Floating-Gates von im wesentlichen allen asymmetrischen Transistoren;
einen selektiven Lösch-Schaltkreis zum selektiven Entfernen der Ladung eines ausgewählten Transistors der wenigstens zwei asymmetrischen Transistoren; und
einen Lese-Schaltkreis zum selektiven Bestimmen, ob das Floating-Gate eines ausgewählten Transistors der wenigstens zwei asymmetrischen Transistoren negativ geladen ist, wobei die Mehrfachanordnung folgendes umfaßt:
ein Halbleitersubstrat, das mehrere im wesentlichen rechteckige Diffusionsbereiche (34) aufweist, die in Reihen und Spalten angeordnet sind, und bei dem:
jeweils erste, zweite, dritte und vierte Source/Drain-Bereiche (36) für die asymmetrischen Transistoren, die sich von den Ecken jedes Diffusionsbereichs (34) erstrecken, wobei sich in jedem Diffusionsbereich jeweils ein Source/Drain-Dotierungsbereich (80, 82) für jeden der Source/Drain-Bereiche (36) befindet,
jeweils eine Floating-Gate-Struktur (38, 76) für jeden asymmetrischen Transistor, die zwischen den Source/Drain-Bereichen (36) der benachbarten Diffusionsbereiche (34) aufgebracht ist, um dazwischen einen Kanal zu bilden,
jeweils eine Steuergate-Struktur (78) für jeden asymmetrischen Transistor, die über jeder Floating-Gate-Struktur (76) aufgebracht ist;
jeweils einen Durchgriffbereich des Fowler-Nordheim-Tunnelns für jeden Transistor, der durch einen dotierten Bereich (84) definiert ist, der jeweils unter einem zugehörigen Source/Drain-Dotierungsbereich (80) und unter einem Teilbereich des zugehörigen Floating-Gates (76) liegt, und
je einen weiteren dotierten Bereich (86) für jeden Transistor, der unterhalb eines anderen Source/Drain-Dotierungsbereichs (82) liegt, aber das zugeordnete Floating-Gate (76) nicht unterschneidet, wobei jede Spaltenleitung (28) mit jeweils einem Diffusionsbereich (34) verbunden ist.

2. Speicher nach Anspruch 1, bei dem die Programmierseite jedes asymmetrischen Transistors (50,52, 56, 58) dessen Source (102) ist.

3. Speicher nach Anspruch 1, bei dem bei jedem der asymmetrischen Transistoren (50, 52, 56, 58) seine Source (102) mit einer Spaltenleitung (28) und sein Drain (92) mit einer benachbarten Spaltenleitung verbunden ist.

4. Speicher nach Anspruch 1, bei dem wenigstens vier der asymmetrischen Transistoren (50, 52, 56, 58) eine Verbindung ihrer Source oder ihres Drains mit einer gemeinsamen Spaltenleitung aufweisen, wobei die vier Transistoren zwei asymmetrische Transistoren aus einer Reihe und zwei asymmetrische Transistoren aus einer anderen Reihe umfassen, wobei diejenigen der vier asymmetrischen Transistoren in einer gemeinsamen Reihe so angeordnet sind, daß die Programmierseite nur eines asymmetrischen Transistors in einer gemeinsamen Reihe mit der gemeinsamen Spaltenleitung verbunden ist.

5. Speicher nach Anspruch 4, bei dem die vier Transistoren (50, 52, 56, 58) in der Konfiguration einer X-Zelle angeordnet sind.

6. Speicher nach Anspruch 5, bei dem sich jeder der asymmetrischen Transistoren (50, 52, 56, 58) innerhalb einer Hochspannungswanne befindet, wobei die Hochspannungswanne aus dem gleichen Leitfähigkeitstyp wie Source oder Drain von jedem der asymmetrischen Transistoren besteht und mit einer Spannung verbunden ist, die kleiner als die des Halbleitermaterials ist, das Source oder Drain der zugehörigen asymmetrischen Transistoren umgibt, so daß sich ein in Sperrichtung gepolter PN-Übergang bildet.

7. Speicher nach Anspruch 1, bei dem der selektive Lösch-Schaltkreis folgendes umfaßt:
eine positive Spannung;
eine negative Spannung; und
einen Schaltkreis zum Verbinden der negativen Spannung mit derjenigen Spaltenleitung, die der Programmierseite der ausgewählten zwei asymmetrischen Transistoren zugeordnet ist, und zum Verbinden der positiven Spannung mit der Reihenleitung, die den ausgewählten zwei Transistoren zugeordnet ist.

8. Speicher nach Anspruch 7, bei dem die negative Spannung niedriger und die positive Spannung höher als die Spannung an Masse ist.

9. Speicher nach Anspruch 7, bei dem der Absolutwert der negativen Spannung im wesentlichen gleich der positiven Spannung ist.

10. Speicher nach Anspruch 9, bei dem sich jeder der asymmetrischen Transistoren (50, 52, 56, 58) innerhalb einer Hochspannungswanne befindet, wobei die Hochspannungswanne aus dem gleichen Leitfähigkeitstyp wie Source oder Drain von jedem der asymmetrischen Transistoren besteht und mit einer Spannung verbunden ist, die kleiner als die des Halbleitermaterials ist, das Source oder Drain der zugehörigen asymmetrischen Transistoren umgibt, so daß sich ein in Sperrichtung gepolter PN-Übergang bildet.

11. Speicher nach Anspruch 1, bei dem der Flash-Schreib-Schaltkreis folgendes umfaßt:
eine positive Spannung;
eine negative Spannung; und
einen Schaltkreis zum Verbinden der negativen Spannung mit allen Spaltenleitungen und zum Verbinden der positiven Spannung mit allen Reihenleitungen.

12. Speicher nach Anspruch 7, bei dem die negative Spannung niedriger und die positive Spannung höher als die Spannung an Masse ist.

13. Speicher nach Anspruch 7, bei dem der Absolutwert der negativen Spannung im wesentlichen gleich der positiven Spannung ist.

14. Speicher nach Anspruch 1, bei dem der Lese-Schaltkreis folgendes umfaßt:
eine positive Lese-Spannung;
eine negative Lese-Spannung;
einen Schaltkreis zum Verbinden der positiven Lese-Spannung mit derjenigen Reihenleitung (26), die einem ausgewählten asymmetrischen Transistor zugeordnet ist, und zum Verbinden der negativen Spannung mit den übrigen Reihenleitungen (26); und
eine Abtastschaltung zum Anlegen einer Spannung über den Kanal von Source (102) und Drain (92) des asymmetrischen Transistors, um festzustellen, ob dieser leitet.

15. Speicher nach Anspruch 14, bei dem sich jeder der asymmetrischen Transistoren (50, 52, 56, 58) innerhalb einer Hochspannungswanne befindet, wobei die Hochspannungswanne aus dem gleichen Leitfähigkeitstyp wie Source oder Drain von jedem der asymmetrischen Transistoren besteht und mit einer Spannung verbunden ist, die kleiner als die des Halbleitermaterials ist, das Source (102) oder Drain (92) der zugehörigen asymmetrischen Transistoren umgibt, so daß sich ein in Sperrichtung gepolter PN-Übergang bildet.

16. Speicher nach Anspruch 14, bei dem die negative Lese-Spannung Masse ist.

17. Speicher nach Anspruch 14, bei dem die negative Lese-Spannung niedriger und die positive Lese-Spannung höher als die Spannung an Masse ist.

## Revendications

1. Mémoire morte effaçable électriquement et programmable électriquement comportant un réseau de mémoire (10), le réseau de mémoire comprenant :
une pluralité de transistors de mémoire dissymétriques (50,52,56,58) disposés suivant des rangées et des colonnes, lesdits transistors dissymétriques comportant une grille de commande (78), une source (102) et un drain (92) séparés par un canal, et une grille flottante (38), lesdits transistors dissymétriques pouvant être activés de manière à être programmés par l'effet tunnel de Fowler-Nordheim à partir seulement d'un côté dudit canal, qui comprend un côté de programmation dudit canal;
une pluralité de lignes (26) de rangées, associées chacune à l'une desdites rangées desdits transistors dissymétriques et connectées aux grilles de commande des transistors dissymétriques associés;
une pluralité de lignes (28) de colonnes, associées chacune à l'une des colonnes desdits transistors dissymétriques;
la source (102) de chacun desdits transistors dissymétriques (50,52,56,58) étant connectée à l'une des lignes (28) de colonnes, tandis que son drain (92) est connecté à une autre desdites lignes de colonnes, la source ou le drain d'au moins l'une de la source ou du drain d'au moins deux desdits transistors dissymétriques de la même rangée étant connecté à une ligne commune faisant partie desdites lignes de colonnes, de telle sorte que le côté de programmation d'un seul desdits au moins deux transistors dissymétriques est connecté à ladite ligne commune de colonnes;
un circuit d'écriture flash pour charger négativement les grilles flottantes essentiellement de l'ensemble desdits transistors dissymétriques;
un circuit d'effacement sélectif pour éliminer sélectivement la charge de l'un sélectif desdits au moins deux transistors dissymétriques; et
un circuit de lecture pour déterminer sélectivement si ladite grille flottante pour l'un sélectionné desdits au moins deux transistors dissymétriques est chargée négativement, dans lequel ledit réseau comprend :
un substrat semiconducteur comportant une pluralité de régions de diffusion essentiellement rectangulaires (34) disposées suivant des rangées et des colonnes, et dans lequel :
des première, seconde, troisième et quatrième régions de source/drain respectives (36) pour lesdits transistors dissymétriques s'étendent à partir des coins de chaque région de diffusion (34), une région respective dopée de source/drain (81,82) pour chacune desdites régions de source/drain (36) étant prévue dans chaque région de diffusion,
une structure de grille flottante (38,76) pour chaque transistor dissymétrique est disposée entre les régions de source/ drain (36) des régions de diffusion adjacentes (34) pour former un canal entre elles,
une structure de grille de commande (78) respective pour chaque transistor dissymétrique est disposée au-dessus de chaque structure de grille flottante (76),
une région respective de traversée à effet tunnel de Fowler-Nordheim pour chaque transistor est définie par une région dopée (84) située au-dessous de l'une associée des régions dopées de source/drain (81) et est située au-dessous d'une partie de la grille flottante associée (76), et
une autre région dopée respective (86) pour chaque transistor est située au-dessous d'une autre associée des régions dopées de source/drain (82), mais n'est pas en contre-dépouille au-dessous de la grille flottante associée (76), chaque ligne (28) de colonnes est connectée à des régions respectives faisant partie desdites régions de diffusion (34).

2. Mémoire selon la revendication 1, dans laquelle le côté programmation de chacun desdits transistors dissymétriques (50,52,56,58) est sa source (102).

3. Mémoire selon la revendication 1, dans laquelle la source (102) de chacun desdits transistors dissymétriques (50,52,56,58) est connectée à l'une desdites lignes (38) de colonnes et son drain (92) est connecté à l'une adjacente desdites lignes de colonnes.

4. Mémoire selon la revendication 1, dans laquelle la source ou le drain d'au moins quatre desdits transistors dissymétriques (50,52,56,58) est connecté à l'une commune desdites lignes de colonnes, lesdits quatre transistors incluant deux desdits transistors dissymétriques appartenant à l'une desdites rangées et deux desdits transistors dissymétriques appartenant à l'autre desdites rangées, et dans lequel les premiers desdits quatre transistors dans une rangée commune sont orientés de telle sorte que le côté de programmation d'un seul desdits transistors dissymétriques dans une rangée commune est connecté à ladite ligne commune de colonnes.

5. Mémoire selon la revendication 4, dans laquelle lesdits quatre transistors (50,52,56,58) sont disposés dans une configuration de cellules X.

6. Mémoire selon la revendication 5, dans laquelle chacun desdits transistors dissymétriques (50,52,56,58) est dans un circuit bouchon à haute tension, ledit circuit bouchon à haute tension ayant le même type de conductivité que celui de la source et du drain de chacun desdits transistors dissymétriques et étant connecté à une tension inférieure à celle du matériau semiconducteur entourant la source et le drain desdits transistors dissymétriques associés, de telle sorte qu'une jonction PN polarisée en inverse est formée.

7. Mémoire selon la revendication 1, dans laquelle ledit circuit d'effacement sélectif comprend :
une tension positive;
une tension négative; et
un circuit pour appliquer ladite tension négative à l'une desdites lignes de colonnes, associées au côté programmation du transistor sélectionné parmi lesdits deux transistors dissymétriques, et appliquer ladite tension positive à ladite ligne de colonnes, associée au transistor sélectionné parmi lesdits deux transistors.

8. Mémoire selon la revendication 7, dans laquelle ladite tension négative est inférieure à la tension de masse et ladite tension positive est supérieure à ladite tension de masse.

9. Mémoire selon la revendication 7, dans laquelle la valeur absolue de ladite tension négative est sensiblement égale à ladite tension positive.

10. Mémoire selon la revendication 9, dans laquelle chacun desdits transistors dissymétriques (50,52, 56,58) est contenu dans un circuit bouchon à haute tension, ledit circuit bouchon à haute tension ayant le même type de conductivité que celui de la source et du drain de chacun desdits transistors dissymétriques et étant connecté à une tension inférieure à celle du matériau semiconducteur entourant la source et le drain desdits transistors dissymétriques associés, de telle sorte qu'une jonction polarisée en inverse est formée.

11. Mémoire selon la revendication 1, dans laquelle ledit circuit d'écriture flash comprend :
une tension positive;
une tension négative; et
un circuit pour appliquer ladite tension négative à l'ensemble desdites lignes de colonnes et ladite tension positive à l'ensemble desdites lignes de rangées.

12. Mémoire selon la revendication 7, dans laquelle ladite tension négative est inférieure à la tension de masse et ladite tension positive est supérieure à ladite tension de masse.

13. Mémoire selon la revendication 7, dans laquelle la valeur absolue de ladite tension négative est sensiblement égale à ladite tension positive.

14. Mémoire selon la revendication 1, dans laquelle ledit circuit de lecture comprend :
une tension de lecture positive;
une tension de lecture négative;
un circuit pour appliquer ladite tension de lecture positive à l'une desdites lignes de rangées (26) associées à un transistor sélectionné parmi lesdits transistors dissymétriques, et appliquer ladite tension négative aux autres lignes faisant partie desdites lignes (26) de rangées; et
un circuit de détection pour appliquer une tension aux bornes du canal de la source (102) et du drain (92) dudit transistor dissymétrique pour déterminer s'il est conducteur.

15. Mémoire selon la revendication 14, dans laquelle chacun desdits transistors dissymétriques (50,52, 56,58) est contenu dans un circuit bouchon à haute tension, ledit circuit bouchon à haute tension ayant le même type de conductivité que celui de la source et du drain de chacun desdits transistors dissymétriques et étant connecté à une tension inférieure à celle du matériau semiconducteur entourant la source (102) et le drain (92) desdits transistors dissymétriques associés, de telle sorte qu'une jonction PN polarisée en inverse est formée.

16. Mémoire selon la revendication 14, dans laquelle ladite tension de lecture négative est la masse.

17. Mémoire selon la revendication 14, dans laquelle ladite tension de lecture négative est une tension inférieure à une tension de masse et ladite tension de lecture positive est supérieure à ladite tension de masse.
